# EUROPÄISCHE PATENTSCHRIFT

(11) **EP 2 351 108 B1**
(45) Veröffentlichungstag und Bekanntmachung des Hinweises auf die Patenterteilung: **29.05.2013**
(21) Anmeldenummer: 09771292.1
(22) Anmeldetag: 17.11.2009
(51) Int. Cl.: H01L 31/0687, H01L 31/18

(54) **Tandemsolarzelle aus kristallinem Silizium und kristallinem Siliziumcarbid sowie Verfahren zu dessen Herstellung**
Tandem solar cell made of crystalline silicon and crystalline silicon carbide as well as method of manufacturing it
Cellule solaire tandem en silicium cristallin et carbure de silicium cristalline et son procédé de fabrication

(30) Priorität: 24.11.2008 EP 08020398
(43) Veröffentlichungstag der Anmeldung: 03.08.2011
(73) Patentinhaber: Fraunhofer-Gesellschaft zur Förderung der angewandten Forschung e.V., 80686 München (DE)
(72) Erfinder: JANZ, Stefan, 79106 Freiburg (DE); REBER, Stefan, 79194 Gundelfingen (DE)
(74) Vertreter: Pfenning, Meinig & Partner GbR
(86) Internationale Anmeldenummer: PCT/EP2009/008163
(87) Internationale Veröffentlichungsnummer: WO 2010/057613

(56) Entgegenhaltungen:
- EP-A- 0 895 291
- US-A- 5 662 965
- REBER S ET AL: "Crystalline silicon thin-film solar cells-recent results at Fraunhofer ISE" 1. Dezember 2004 (2004-12-01), SOLAR ENERGY, PERGAMON PRESS. OXFORD, GB, PAGE(S) 865 - 875 , XP004661827 ISSN: 0038-092X das ganze Dokument
- BAU S ET AL: "Application of PECVD-SiC as intermediate layer in crystalline silicon thin-film solar cells" PROCEEDINGS OF 3RD WORLD CONFERENCE ON PHOTOVOLTAIC ENERGY CONVERSION (IEEE CAT. NO.03CH37497) ARISUMI PRINTING INC JAPAN, JAPAN, Bd. 2, 2003, Seiten 1178-1181 Vol., XP002552832 ISBN: 4-9901816-0-3

## Beschreibung

Die Erfindung beschreibt photovoltaische Tandemsolarzellen aus kristallinem Silizium und kristallinem Siliziumcarbid mit einer Si/C-Zwischenschicht. Ferner beschreibt die Erfindung ein Verfahren zur Herstellung von Tandemsolarzellen.

Solarzellen sind aus dem Stand der Technik bekannt. Der Photovoltaikmarkt weltweit ist derzeit von Wafer-Solarzellen aus kristallinem Silizium dominiert. Da die technologische Entwicklung dieses Konzeptes schon sehr weit fortgeschritten ist, ist der theoretisch mögliche Maximalwirkungsgrad bei Forschungssolarzellen bereits zu ca. 90 % erreicht. Bei industriell in Serie gefertigten Si-Wafer-Solarzellen wird durch Skalierung und Anpassung der dafür verwendeten Technologien angestrebt, diesen Bestwirkungsgrad zu aproximieren.

Die US 5,057,163 beschreibt eine Dünnschichtsolarzelle aus polykristallinem Silizium auf einem keramischen Material mit einer Reflexionsschicht. Durch den Einsatz einer photoaktiven Schicht, wie in dem in der Offenbarung beschriebenen Beispiel, kann der Spektralbereich des einfallenden Lichts nur teilweise für die Energiegewinnung genutzt werden.

In der US 4,419,533 ist eine photovoltaische Vorrichtung aus verschiedenartigen Halbleiterverbindungen und einer Reflektorschicht, die einen unspezifischen Teil des einfallenden Lichts zurückstrahlt, offenbart.

Die EP 0 895 291 beschreibt eine photovoltaische Tandemzelle mit einer ersten photoaktiven Schicht aus mikrokristallinem Siliziumkarbid und einer zweiten photoaktiven Schicht aus mikrokristallinem Silizium.

Die US 5,662,965 beschreibt kristalline kohlenstoffbasierte Dünnfilmstrukturen, z.B. aus Siliziumcarbid oder Diamant, wobei zunächst eine Zwischenschicht auf einem Substrat abgeschieden wird und dann eine kristalline kohlenstoffbasierte Dünnschicht auf der Zwischenschicht abgeschieden wird.

Die aus dem Stand der Technik bekannten Solarzellen enthalten unter anderem amorphes Silizium und weisen somit einen höheren Grad an Unordnung in deren Kristallstruktur auf. Bei dem Einsatz von nur einer photovoltaischen Schicht kann demzufolge ein kleinerer Anteil des Lichts in Energie umwandeln und somit nur ein geringerer Wirkungsgrad erzielt werden. Ausgehend hiervon ist es Aufgabe der vorliegenden Erfindung, die Nachteile des Standes der Technik zu beseitigen und eine photovoltaische Tandemsolarzelle sowie ein Verfahren zu dessen Herstellung bereitzustellen, so dass durch den Aufbau aus mehreren Schichten ein größerer Anteil des spektralen Bereichs zur Energiegewinnung eingesetzt werden kann und durch den geordneten Aufbau der Schichten ein hohes Maß an Kristallordnung gewährt ist, die den erreichbaren Wirkungsgrad zusätzlich erhöht.

Diese Aufgabe wird durch die photovoltaische Tandemzelle mit den Merkmalen des Anspruchs 1 gelöst. Anspruch 15 betrifft ein Verfahren zur Herstellung von photovoltaischen Tandemzellen. Weitere vorteilhafte Ausführungsformen sind in den abhängigen Ansprüchen 2 bis 14 enthalten.

Die Erfindung umfasst eine photovoltaische Tandemzelle mit mindestens zwei photoaktiven Schichten, bestehend aus jeweils einem n-dotierten Emitter und einem p-dotierten Bereich, und mindestens einer Zwischenschicht, wobei die mindestens eine erste photoaktive Schicht Siliziumcarbid und die mindestens eine zweite photoaktive Schicht Silizium enthält oder daraus besteht und die mindestens eine Zwischenschicht eine Si/C-Mischschicht ist. Die erste photoaktive Schicht ist dabei die dem Licht zugewandte Vorderseite und die zweite photoaktive Schicht bildet die Rückseite der photovoltaischen Zelle und damit die dem Substrat zugewandte Seite. Wesentlich ist dabei, dass mindestens der n-dotierte Emitter und/oder der p-dotierte Bereich mindestens einer Schicht epitaktisch abgeschieden worden ist.

Der Aufbau aus mindestens zwei photoaktiven Schichten ermöglicht eine bessere Ausnutzung des Spektralbereiches von Sonnenlicht. In Abhängigkeit von dem Abstand zwischen den Energieniveaus werden die dieser Energie entsprechenden Wellenlängen absorbiert. Da hier mindestens zwei verschiedene Photoschichten enthalten sind, die aufgrund ihrer chemischen Zusammensetzung verschiedene Energieabstände aufweisen und somit in verschiedenen Wellenlängenbereichen Licht absorbieren, wird so ein größerer Spektralbereich zur Energiegewinnung genutzt.

In einer bevorzugten Ausführungsform ist die photovoltaische Tandemzelle monolithisch. Dieser Aufbau bewirkt eine höhere Stabilität der Solarzelle, sowie eine Struktur, die eine geringe Zahl an Störzellen besitzt.

Bevorzugt weist die erste photoaktive Schicht, die eine Siliziumcarbidschicht ist, eine Dicke von maximal 40 µm auf. Für diese Schichtdicke gilt, dass das einfallende Licht geeigneter Wellenlänge gut absorbiert werden kann sowie eine Durchstrahlung der Schicht ermöglicht ist. Grundsätzlich könnte die erste Schicht auch aus zwei oder mehreren Schichten aus SiC bestehen.

Zentrales Element der vorliegenden Erfindung ist, dass zwischen den beiden photoaktiven Schichten mindestens eine Si/C-Mischschicht vorhanden ist, die durch ein angepasstes Si/C-Verhältnis eine Gitteranpassung an die photoaktiven Schichten aufweist.

Die Anpassung des Si/C-Verhältnisses der Si/C-Mischschicht erfolgt durch die Abnahme des Siliziumgehalts und der dazu direkt proportionalen Zunahme des Kohlenstoffgehalts in Abhängigkeit von der Dicke der Zwischenschicht. Die Abnahme des Siliziumgehalts erfolgt in Richtung von der Silizium-Schicht zu der Siliziumcarbid-Schicht. So werden Spannungen in der Struktur vermindert und die Anzahl der Versetzungen in Si/C-Kristall minimiert. Die Gitteranpassung an die photoaktiven Schichten ermöglicht somit einen hohen Energiegewinn durch optimale Ausnutzung des einfallenden Lichts.

Die Dicke der Zwischenschicht beträgt günstigerweise maximal 10 µm. So wird einerseits eine Gitteranpassung ermöglicht, andererseits ist diese Schichtdicke durchstrahlbar, so dass der Lichtverlust möglichst gering gehalten werden kann.

Die Erfindung umfasst selbstverständlich auch Ausführungsformen der photovoltaischen Tandemzelle, bei der die Zwischenschicht aus zwei Si/C-Mischschichten besteht. Dies erleichtert die Verarbeitung während des Herstellungsprozesses.

Bevorzugt wird als Substrat eine auf einen monokristallinen Siliziumwafer abgeschiedene Siliziumschicht oder ein solarzellentauglicher Siliziumwafer eingesetzt. Diese weisen einen hohen Grad an Ordnung auf.

In einer vorzugsweisen Ausführungsform der photovoltaischen Tandemzelle beträgt die Dicke der mindestens einen photovoltaischen Schicht, die aus Si besteht, maximal 50 µm. Damit wird sowohl die Absorption des Lichts mit geeignetem Wellenlängenbereich gewährleistet, als auch eine bestimmte Stabilität der Tandemsolarzelle erhalten. Auch die Si-Schicht kann durch zwei oder mehrere Einzelschichten gebildet sein.

Bevorzugt ist mindestens der hochdotierte Emitter einer ersten und/oder zweiten photoaktiven Schicht mittels Gasphasenabscheidung epitaktisch gebildet worden. So wird eine hohe Gleichmäßigkeit der Dotierung und auch der abgeschiedenen Schicht erhalten. Die Zahl der unerwünschten Störstellen im Kristall ist folglich gering. Ferner wird durch diese Art der Auftragung eine besonders stabile Schichtenfolge erhalten.

In einer weiteren bevorzugten Ausführungsform ist die Zwischenschicht mittels schneller thermischer Gasphasen-Abscheidung in einem Temperaturbereich von 800 bis 1400°C und einem Druckbereich von 1 mbar bis 1 bar gebildet worden. In diesem Temperatur- und Druckbereich wird ein optimales Ergebnis ermöglicht.

Die aus Siliziumcarbid bestehende Schicht wir bevorzugt mittels Gasphasen-Abscheidung in einem Temperaturbereich von 800 bis 1400°C und einem Druckbereich von 1 mbar bis 1 bar gebildet. So kann die Schichtdicke und der Aufbau der Siliziumcarbidschicht sehr genau verfolgt und gesteuert werden.

In einer weiteren bevorzugten Ausführungsform ist die photovoltaische Tandemzelle an der Vorder- und Rückseite elektrisch kontaktiert worden. Diese Form der Kontaktierung stellt technologisch eine wesentliche Erleichterung dar, da durch einer geringeren Zahl an Kontakt- bzw. Lötstellen die Verarbeitungsdauer beschleunigt wird.

In einer alternativen Ausführungsform sind die photoaktiven Schichten vorzugsweise einzeln verschaltet worden. Hier dient die Zwischenschicht der ausschließlich der Angleichung der beiden Gitterkonstanten. Elektrisch sind diese beiden Solarzellen nicht über die Si/C Zwischenschicht miteinander verbunden.

Die Erfindung stellt auch ein Verfahren zur Herstellung einer photovoltaischen Tandemzelle, wie beschrieben, bereit, das dadurch gekennzeichnet ist, dass mindestens der n-dotierte Emitter und/oder der p-dotierte Bereich mindestens einer Schicht mittels eines epitaktischen Verfahren abgeschieden wird. So wird eine Silizium/Siliziumcarbid-Tandem-Dünnschichtsolarzelle erhalten, die sowohl eine hohe Stabilität als auch einen deutlich höheren Wirkungsgrad im Vergleich zu Solarzellen mit nur einer photoaktiven Schicht aufweist.

Die beschriebene Schichtstruktur kann auch für Sensoren oder Si-basierte Leuchtdioden interessant sein.

Anhand der folgenden Figuren 1 bis 2 und Ausführungsbeispielen 1 bis 2 soll der anmeldungsgemäße Gegenstand näher erläutert werden, ohne diesen auf die hier genannten Varianten einzuschränken.
- Figur 1: zeigt eine monolithisch verschaltete Tandem-Solarzelle.
- Figur 2: zeigt eine Tandemsolarzelle mit Einzelverschaltung.

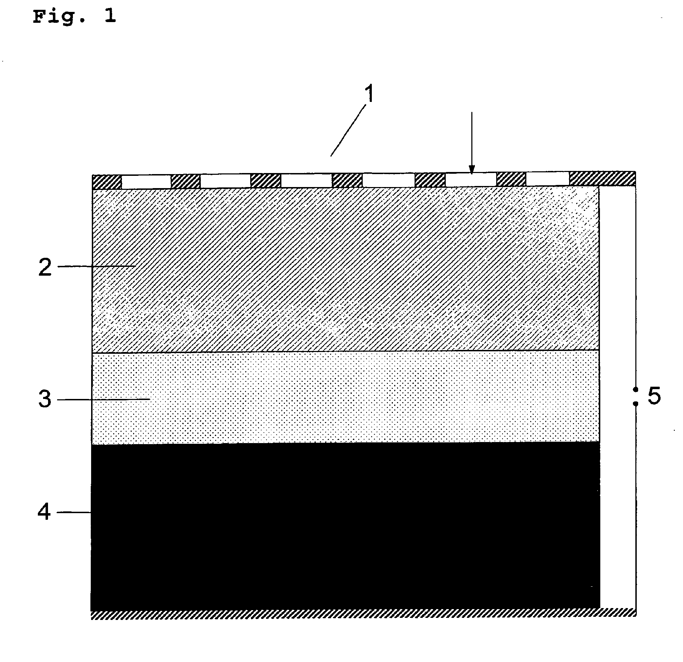

In Figur 1 ist eine monolithisch verschaltete Tandemsolarzelle 1 aus kristallinem Silizium 4 und kristallinem Siliziumcarbid 2 dargestellt, das durch die kristalline Si/C-Zwischenschicht 3 verbunden ist. Sie ist auf der Vorder- und Rückseite mit elektrischen Kontakten 5 versehen. Der Pfeil kennzeichnet die zu bestrahlende Vorderseite. Die Dicke der Schicht 2 beträgt mindestens 5 µm und die der Schicht 4 mindestens 10 µm. Die Si/C-Mischschicht besitzt eine Dicke von weniger als 1 µm.

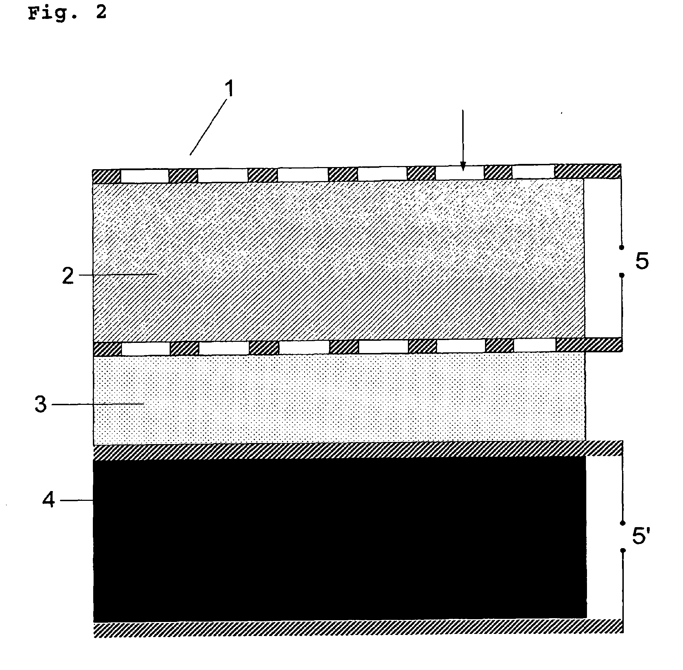

Figur 2 zeigt die Einzelverschaltung einer Tandemsolarzelle 1 analog Figur 1. Diese weist eine Schicht aus kristallinem Siliziumcarbid 2 auf. Sie ist über die Si/C-Zwischenschicht 3 mit der kristallinen Siliziumcarbidschicht 4 verbunden. Hier werden beide photoaktiven Bereiche einzeln elektrisch kontaktiert 5, 5'. Durch den Pfeil weist auf die dem Sonnenlicht zugewandte Vorderseite der photovoltaischen Tandemsolarzelle.

### Beispiel 1

Beide Materialien werden mit Hilfe der Gasphasenabscheidung (CVD), z.B. aus Chlorsilanen, epitaktisch gewachsen. Das Ausgangssubstrat ist eine auf einen p-dotierten Siliziumwafer 4 abgeschiedene n-dotierte Emitterschicht. Die Emitterschicht weist eine Dicke von 2 µm auf. Die Zwischenschicht 3 besteht aus zwei sehr dünnen, deutlich kleineren als 1 µm, hochdotierten (p⁺⁺/n⁺⁺) Si/C-Mischschichten, die mittels RTCVD (schneller thermischer Gasphasenabscheidung) gewachsen werden. Die Basis der SiC-Zelle 2 und anschließend der Emitter (n⁺) werden wiederum mittels CVD gewachsen. Die Tandemsolarzelle 1 wird an Vorder-und Rückseite elektrisch kontaktiert 5 (monolithische Verschaltung).

### Beispiel 2

Ausgangssubstrat ist ein solarzellentauglicher Siliziumwafer 4. Die Zwischenschicht 3 wird mittels schneller thermischer Gasphasenabscheidung in einem Temperaturbereich von 800 bis 1400 °C und einem Druckbereich von 1 mbar bis 1 bar gebildet. Im Anschluss wird die Basis der Siliziumcarbidzelle (p) 2 und anschließend der Emitter (n⁺) mittels CVD (thermischer Gasphasenabscheidung) gewachsen. Dies erfolgt in einem Druckbereich von 1 mbar bis 1 bar und in einem Temperaturbereich von 800 bis 1400 °C. Die Kontaktierung der Tandemsolarzelle 1 erfolgt über die Einzelverschaltung 5, 5' der Siliziumcarbidschicht 2 und der Siliziumschicht 4 (mechanische Stapelung).

## Patentansprüche

1. Photovoltaische Tandemzelle (1) mit mindestens zwei photoaktiven Schichten (2, 4) mit einem hohen Maß an Kristallordnung, bestehend aus jeweils einem n-dotierten Emitter und einem p-dotierten Bereich, und mindestens einer Zwischenschicht (3),wobei die mindestens eine erste photoaktive Schicht (2) Siliziumcarbid und die mindestens eine zweite photoaktive Schicht (4) Silizium enthält oder daraus besteht und die mindestens eine erste photoaktive Schicht (2) die dem Licht zugewandte Vorderseite und die mindestens eine zweite photoaktive Schicht (4) die Rückseite der photovoltaischen Zelle (1) und damit dem Substrat zugewandte Seite darstellt,
**dadurch gekennzeichnet,**
**dass** die Zwischenschicht (3) mindestens eine Si/C-Mischschicht ist, und dass mindestens der n-dotierte Emitter und/oder der p-dotierte Bereich mindestens einer Schicht epitaktisch abgeschieden worden ist.

2. Photovoltaische Tandemzelle (1) gemäß Anspruch 1, **dadurch gekennzeichnet, dass** diese monolithisch ist.

3. Photovoltaische Tandemzelle (1) gemäß mindestens einem der Ansprüche 1 bis 2, **dadurch gekennzeichnet, dass** die Dicke der ersten photoaktiven Schicht (2) maximal 40 µm beträgt.

4. Photovoltaische Tandemzelle(1) gemäß mindestens einem der Ansprüche 1 bis 3, **dadurch gekennzeichnet, dass** die mindestens eine Si/C-Mischschicht (3) eine Gitteranpassung an die mindestens zwei photoaktiven Schichten (2, 4) durch ein angepasstes Si/C-Verhältnis aufweist.

5. Photovoltaische Tandemzelle (1) gemäß mindestens einem der Ansprüche 1 bis 4, **dadurch gekennzeichnet, dass** die Anpassung des Si/C-Verhältnisses der Si/C-Mischschicht (3) durch die Abnahme des Siliziumgehalts und der dazu proportionalen Zunahme des Kohlenstoffgehalts in Abhängigkeit von der Zwischenschicht-Dicke und in Richtung von der mindestens einen photoaktiven Schicht (4) zur mindestens einen photoaktiven Schicht (2) erfolgt.

6. Photovoltaische Tandemzelle (1) gemäß mindestens einem der Ansprüche 1 bis 5, **dadurch gekennzeichnet, dass** die Dicke der mindestens einen Zwischenschicht (3) maximal 10 µm beträgt.

7. Photovoltaische Tandemzelle (1) gemäß mindestens einem der Ansprüche 1 bis 6, **dadurch gekennzeichnet, dass** die Zwischenschicht (3) aus zwei Si/C-Mischschichten besteht.

8. Photovoltaische Tandemzelle (1) gemäß mindestens einem der Ansprüche 1 bis 7, **dadurch gekennzeichnet, dass** als Substrat eine auf einen monokristallinen Silizium-Wafer abgeschiedene Siliziumschicht (4) oder ein solarzellentauglicher Silizium-Wafer (4) eingesetzt worden ist.

9. Photovoltaische Tandemzelle (1) gemäß mindestens einem der Ansprüche 1 bis 8, **dadurch gekennzeichnet, dass** die Dicke der mindestens einen photoaktiven Schicht (4) maximal 50 µm beträgt.

10. Photovoltaische Tandemzelle (1) gemäß mindestens einem der Ansprüche von 1 bis 9, **dadurch gekennzeichnet, dass** mindestens der n-dotierte Emitter einer ersten (2) und/oder zweiten photoaktiven Schicht (4) mittels Gasphasen-Abscheidung epitaktisch gebildet worden ist.

11. Photovoltaische Tandemzelle (1) gemäß mindestens einem der Ansprüche 1 bis 10, **dadurch gekennzeichnet, dass** die mindestens eine Zwischenschicht (3) mittels thermischer Gasphasen-Abscheidung in einem Temperaturbereich von 800 bis 1400°C und einem Druckbereich von 1 mbar bis 1 bar gebildet worden ist.

12. Photovoltaische Tandemzelle (1) gemäß mindestens einem der Ansprüche 1 bis 11, **dadurch gekennzeichnet, dass** die mindestens eine photoaktive Schicht (2) mittels Gasphasen-Abscheidung in einem Temperaturbereich von 800 bis 1400°C und einem Druckbereich von 1 mbar bis 1 bar gebildet worden ist.

13. Photovoltaische Tandemzelle (1) gemäß mindestens einem der Ansprüche 1 bis 12, **dadurch gekennzeichnet, dass** die Tandemsolarzelle (1) an der Vorder- und Rückseite über eine Verschaltung (5) elektrisch kontaktiert worden ist.

14. Photovoltaische Tandemzelle (1) gemäß mindestens einem der Ansprüche 1 bis 13, **dadurch gekennzeichnet, dass** die photoaktiven Schichten (2, 4) über Einzelverschaltungen (5, 5') verschaltet worden sind.

15. Verfahren zur Herstellung einer photovoltaischen Tandemzelle (1) gemäß mindestens einem der Ansprüche 1 bis 14, **dadurch gekennzeichnet, dass** mindestens der n-dotierte Emitter und/oder der p-dotierte Bereich mindestens einer Schicht mittels einem epitaktischen Verfahren abgeschieden wird.

## Claims

1. Photovoltaic tandem cell (1) having at least two photoactive layers (2, 4) with a high degree of crystal order, consisting of respectively one n-doped emitter and one p-doped region and at least one intermediate layer (3), wherein the at least one first photoactive layer (2) comprises silicon carbide and the at least one second photoactive layer (4) silicon or consists thereof and the at least one first photoactive layer (2) representing the front-side orientated towards the light and the at least one second photoactive layer (4) the rear-side of the photovoltaic cell (1) and hence the side orientated towards the substrate,
**characterized in that** the intermediate layer (3) is at least one Si/C mixed layer and that at least the n-doped emitter and/or the p-doped region of at least one layer was deposited epitaxially.

2. Photovoltaic tandem cell (1) according to claim 1, **characterised in that** the photovoltaic tandem cell is monolithic.

3. Photovoltaic tandem cell (1) according to at least one of the claims 1 to 2, **characterised in that** the thickness of the first photoactive layer (2) is at most 40 µm.

4. Photovoltaic tandem cell (1) according to at least one of the claims 1 to 3, **characterised in that** the at least one Si/C mixed layer (3) has a lattice adaptation to the at least two photoactive layers (2, 4) due to an adapted Si/C ratio.

5. Photovoltaic tandem cell (1) according to at least one of the claims 1 to 4, **characterised in that** the adaptation of the Si/C ratio of the Si/C mixed layer (3) is effected by the reduction in the silicon content and the increase, proportional thereto, in the carbon content as a function of the thickness of the intermediate layer and in the direction from the at least one photoactive layer (4) to the at least one photoactive layer (2).

6. Photovoltaic tandem cell (1) according to at least one of the claims 1 to 5, **characterised in that** the thickness of the at least one intermediate layer (3) is at most 10 µm.

7. Photovoltaic tandem cell (1) according to at least one of the claims 1 to 6, **characterised in that** the intermediate layer (3) consists of two Si/C mixed layers.

8. Photovoltaic tandem cell (1) according to at least one of the claims 1 to 7, **characterised in that** a silicon layer (4) deposited on a monocrystalline silicon wafer or a silicon wafer (4) which is suitable for solar cells was used as substrate.

9. Photovoltaic tandem cell (1) according to at least one of the claims 1 to 8, **characterised in that** the thickness of the at least one photoactive layer (4) is at most 50 µm.

10. Photovoltaic tandem cell (1) according to at least one of the claims 1 to 9, **characterised in that** at least the n-doped emitter of a first (2) and/or second photoactive layer (4) was formed epitaxially by means of vapour-phase deposition.

11. Photovoltaic tandem cell (1) according to at least one of the claims 1 to 10, **characterised in that** the at least one intermediate layer (3) was formed by means of thermal vapour-phase deposition in a temperature range of 800 to 1,400°C and in a pressure range of 1 mbar to 1 bar.

12. Photovoltaic tandem cell (1) according to at least one of the claims 1 to 11, **characterised in that** the at least one photoactive layer (2) was formed by means of vapour-phase deposition in a temperature range of 800 to 1,400°C and a pressure range of 1 mbar to 1 bar.

13. Photovoltaic tandem cell (1) according to at least one of the claims 1 to 12, **characterised in that** the tandem solar cell (1) was contacted electrically on the front- and rear-side via wiring (5).

14. Photovoltaic tandem cell (1) according to at least one of the claims 1 to 13, **characterised in that** the photoactive layers (2, 4) were wired via individual wirings (5, 5').

15. Method for the production of a photovoltaic tandem cell (1) according to at least one of the claims 1 to 14, **characterised in that** at least the n-doped emitter and/or the p-doped region of at least one layer is deposited by means of an epitaxial process.

## Revendications

1. Cellule photovoltaïque tandem (1) avec au moins deux couches photo-actives (2, 4) avec un degré élevé d'organisation cristalline, respectivement constituée d'un émetteur dopé n et d'une zone dopée p, et au moins une couche intermédiaire (3), dans laquelle la au moins une première couche photo-active (2) contient du carbure de silicium et la au moins une deuxième couche photo-active (4) contient du silicium ou en est constituée et la au moins une première couche photo-active (2) représente le côté avant orienté vers la lumière et la au moins une deuxième couche photo-active (4) représente le côté arrière de la cellule photovoltaïque (1) et donc le côté orienté vers le substrat,
**caractérisée en ce que**
la couche intermédiaire (3) est au moins une couche de mélange Si/C et **en ce qu'**au moins l'émetteur dopé n et/ou la zone dopée p d'au moins une couche a été déposée épitaxialement.

2. Cellule photovoltaïque tandem (1) selon la revendication 1, **caractérisée en ce que** celle-ci est monolithique.

3. Cellule photovoltaïque tandem (1) selon au moins une des revendications 1 à 2, **caractérisée en ce que** l'épaisseur de la première couche photo-active (2) s'élève au maximum à 40 µm.

4. Cellule photovoltaïque tandem (1) selon au moins une des revendications 1 à 3, **caractérisée en ce que** la au moins une couche de mélange Si/C (3) présente une adaptation de grille sur les au moins deux couche photo-actives (2, 4) grâce à un rapport Si/C adapté.

5. Cellule photovoltaïque tandem (1) selon au moins une des revendications 1 à 4, **caractérisée en ce que** l'adaptation du rapport Si/C de la couche de mélange Si/C (3) a lieu grâce à la réduction de la teneur en silicium et de l'augmentation proportionnelle en conséquence de la teneur en carbone en fonction de l'épaisseur de la couche intermédiaire et en direction de la au moins une couche photo-active (4) vers la au moins une couche photo-active (2).

6. Cellule photovoltaïque tandem (1) selon au moins une des revendications 1 à 5, **caractérisée en ce que** l'épaisseur de la au moins une couche intermédiaire (3) s'élève au maximum à 10 µm.

7. Cellule photovoltaïque tandem (1) selon au moins une des revendications 1 à 6, **caractérisée en ce que** la couche intermédiaire (3) est constituée de deux couches de mélange Si/C.

8. Cellule photovoltaïque tandem (1) selon au moins une des revendications 1 à 7, **caractérisée en ce que**, comme substrat, une couche de silicium (4) déposée sur une plaquette de silicium monocristalline ou une plaquette de silicium (4) adaptée pour des cellules solaires a été utilisée.

9. Cellule photovoltaïque tandem (1) selon au moins une des revendications 1 à 8, **caractérisée en ce que** l'épaisseur de la au moins une couche photo-active (4) s'élève au maximum à 50 µm.

10. Cellule photovoltaïque tandem (1) selon au moins une des revendications 1 à 9, **caractérisée en ce qu'**au moins l'émetteur dopé n d'une première (2) et/ou deuxième (4) couche photo-active a été formé épitaxialement au moyen d'un dépôt chimique en phase vapeur.

11. Cellule photovoltaïque tandem (1) selon au moins une des revendications 1 à 10, **caractérisée en ce que** la au moins une couche intermédiaire (3) a été formée au moyen d'un dépôt chimique thermique en phase vapeur dans un domaine de température de 800 à 1400 °C et un domaine de pression de 1 mbar à 1 bar.

12. Cellule photovoltaïque tandem (1) selon au moins une des revendications 1 à 11, **caractérisée en ce que** la au moins une couche photo-active (2) a été formée au moyen d'un dépôt chimique en phase vapeur dans un domaine de température de 800 à 1 400 °C et un domaine de pression de 1 mbar à 1 bar.

13. Cellule photovoltaïque tandem (1) selon au moins une des revendications 1 à 12, **caractérisée en ce que** la cellule solaire tandem (1) a été électriquement mise en contact sur les côtés avant et arrière via un circuit de raccordement (5).

14. Cellule photovoltaïque tandem (1) selon au moins une des revendications 1 à 13, **caractérisée en ce que** les couches photo-actives (2, 4) ont été raccordées via des circuits de raccordement individuels (5, 5').

15. Procédé de fabrication d'une cellule photovoltaïque tandem (1) selon au moins une des revendications 1 à 14, **caractérisé en ce qu'**au moins l'émetteur dopé n et/ou la zone dopée p d'au moins une couche est déposé au moyen d'un procédé épitaxial.
